# EUROPEAN PATENT SPECIFICATION

(11) **EP 0 256 494 B1**
(45) Date of publication and mention of the grant of the patent: **07.01.1993**
(21) Application number: 87111603.4
(22) Date of filing: 11.08.1987
(51) Int. Cl.: H01L 23/52

(54) **Activatable conductive links for semiconductor devices**
Leitende Aktivierungsverbindungen für Halbleiteranordnungen
Liens conducteurs activables pour dispositifs semi-conducteurs

(30) Priority: 12.08.1986 JP 189094/86
(43) Date of publication of application: 24.02.1988
(73) Proprietor: FUJITSU LIMITED, Kawasaki-shi, Kanagawa 211 (JP)
(72) Inventor: Mukai, Ryoichi FUJITSU LIMITED Patent Department, Nakahara-ku Kawasaki-shi Kanagawa 211 (JP)
(74) Representative: Sunderland, James Harry

(56) References cited:
- EP-A- 0 167 732
- EP-A- 0 251 523
- IBM TECHNICAL DISCLOSURE BULLETIN, vol. 21, no. 1, June 1978, page 268, Armonk, New York, US; W.W. WU: "Laser connection and disconnection scheme"
- Idem
- IEEE ELECTRON DEVICE LETTERS, vol. EDL-7, no. 1, January 1986, pages 1-4, IEEE, New York, US; D.B. TUCKERMAN et al.: "Planarization of gold and aluminum thin films using a pulsed laser"
- Idem
- ELECTRONICS, vol. 55, no. 14, 14th July 1982, pages 159-162, New York, US; W.W. WU: "Automated welding customizes programmable logic arrays"
- IBM TECHNICAL DISCLOSURE BULLETIN, vol. 21, no. 3, August 1978, pages 1027-1028, Armonk, New York, US; R.E. SCHEUERLEIN: "Joining metal lines with a laser beam tool"
- PROCEEDINGS OF THE IEEE 1986 CUSTOM INTEGRATED CIRCUITS CONFERENCE, Rochester, New York, 12th-15th May 1986, pages 591-593, IEEE; C.R. MUSIL et al.: "Focused ion beam microsurgery for integrated circuit customization of repair"
- IEEE ELECTRON DEVICE LETTERS, vol. EDL-8, no. 2, February 1987, pages 76-78, IEEE, New York, US; R. MUKAI et al.: "High-aspect-ratio via-hole filling with aluminum melting by excimer laser irradiation for multilevel interconnection"

## Description

This invention relates to activatable conductive links for integrated circuit (IC) semiconductor devices, more particularly to an activatable conductive link disposed between electrically insulated metallic conductive wirings formed in an IC and activatable to establish a conducting path between the wirings when necessary.

An activatable conductive link is disposed between conductive wirings which are insulated from each other. Although called a conductive link, the link is initially electrically insulative but can be converted to a conductive condition, when required, by the application of an activating operation thereto.

Activatable conductive links are frequently used in cooperation with fuses in IC devices such as programmable read only memories, gate arrays and the like, which are fabricated using a master slice system. In these ICs, in accordance with a customer's order, circuit blocks previously formed therein are selectively connected to each other or disconnected from each other using the conductive links or fuses which are activated (put into operation) by irradiation with an energy beam, usually a laser beam.

As the degree of integration of ICs grows, the necessity for the provision of redundancy within IC chips increases in order to enhance production yield of IC devices. Redundancy is implemented by providing an IC, such as a memory chip, with spare circuitry such as spare rows or spare columns for memory cells which are tested after the final fabrication step thereof is finished. Thereafter, bad circuitry is selectively rejected by disconnecting the relevant wirings by blowing previously formed relevant fuses, and is replaced by spare circuitry by activating relevant previously formed conductive links. An example of such redundancy technology is reported by James B. Binton on pages 39 and 40 of Electronics, July 28, 1981, in which example conductive pathways (links) of metal-silicon alloy are selectively activated by the irradiation of an argon laser beam between metal layers.

One activatable conductive link currently in use will be described in relation to master slice production of a semiconductor device, wherein basic circuits are formed on a semiconductor substrate in advance, and thereafter complete circuits of various types, combining basic circuits, are formed in accordance with customers' orders, by selectively changing interconnecting wirings between the basic circuits.

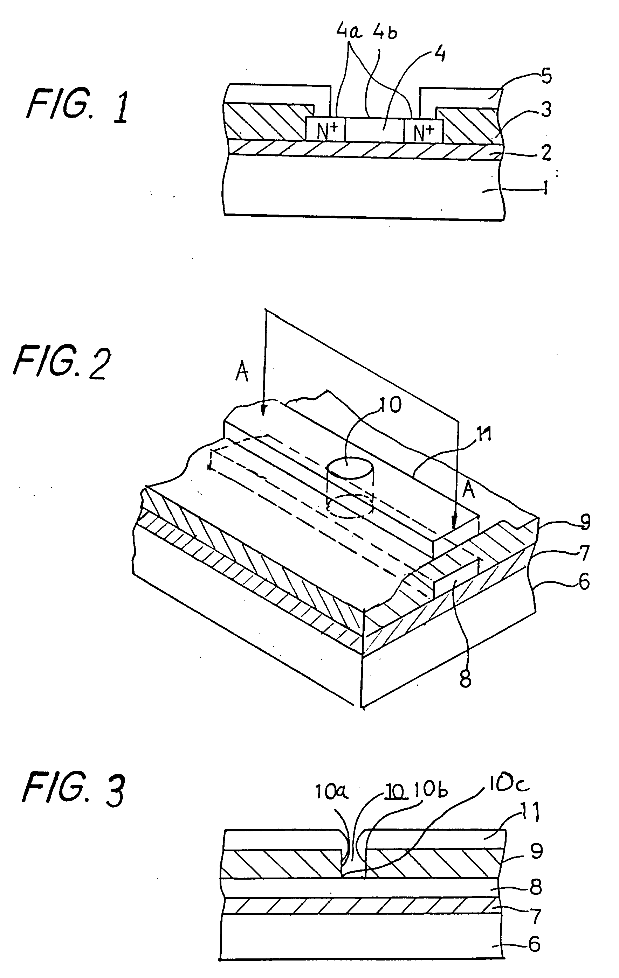

Fig. 1 is a cross-sectional view, illustrating a conductive link for changing interconnecting wirings. 1 is silicon substrate, 2 is a silicon dioxide (SiO₂) layer formed on the silicon substrate 1, 3 is a phospho-silicate-glass (PSG) layer formed as an insulating layer interposed between the associated layers, 4 is an activatable conductive element made of polycrystalline silicon (polysilicon), and 5 is an aluminium layer. Portions 4a of the polysilicon of the activatable conductive element 4 which contact the aluminium layer 5 are highly doped with phosphorous dopants, having a low electrical resistance, but a centre portion 4b of the element 4 is non-doped, having high electrical resistance.

It will be assumed that in order to set up a required complete circuit system, the polysilicon element 4 is required to be changed to a conductive condition. To achieve this, the element 4 is irradiated by a continuous wave laser beam. As a result, phosphorus dopants contained in the high doped portions 4a of the element 4 are diffused into the non-doped portion 4b, changing that portion 4b into a conductive portion, thus activating the element 4 as a conductive element.

With regard to the need for high integration packing density of ICs, the areas taken up by conductive links or fuses on chips are required to be as small as possible. The above-described activatable conductive element 4 occupies a considerable area on the substrate 1, reducing integration density, and its formation involves complicated fabrication steps.

IBM Technical Disclosure Bulletin Vol. 21, No. 1, June 1978, page 268, and Vol.21, No.3, August 1978, page 1027 discloses a structure which provides that one laser shot can make a connection between two conductive lines on a silicon dioxide layer. The lines end in two closely juxtaposed but initially separated lands. Directly over these lands and under the silicon dioxide layer is a metal square. The two lands in the square form the laser target. When the target is hit by the laser beam the two lands are welded to the metal square to connect the lines.

IEEE Electron Device Letters, Vol. EDL-7, No. 1, January 1986, pages 1 to 4, discusses the planarisation of gold and aluminium thin films using a pulsed laser. Planarisation of films extending over via holes is discussed.

Attention is also directed to EP-A-0 251 523, which forms part of the state of the art by virtue of Article 54(3) EPC.

According to the present invention there is provided an activatable conductive link structure in a semiconductor device, the structure comprising in its non-activated, non-conductive, configuration, a void in an insulating layer of the semiconductor device across which void conductive parts of the device confront one another, the void being such that conductive material does not extend to such an extent, on inner walls of the void as to establish conductive connection between the conductive parts, and such that upon activation of the link conductive material of at least one of the confronting conductive parts melts and fills the void to establish a conductive link between the conductive parts.

According to the present invention there is also provided a method of forming and activating an activatable conductive link structure in a semiconductor device, the method comprising
forming a void in an insulating layer of the device with conductive parts of the device confronting one another across the void, to provide a non-conductive, non-activated link structure, the void being such that conductive material does not extend on inner walls of the void to establish conductive connection between the conductive parts, for example the void having such an aspect ratio, i.e. ratio of depth into the insulating layer to upper opening width, as to prevent deposition of conductive material on its inner walls such as would establish a conductive connection between the conductive parts,
and activating the link structure by locally heating a region in the vicinity of the void such that conductive material of at least one of the conductive parts melts and fills the void to establish a conductive link between the conductive parts.

An embodiment of the present invention can provide an activatable conductive link for connecting two aluminium or aluminium alloy wirings, initially insulated from each other, by activating the conductive link.

An embodiment of the present invention can provide an activatable conductive link for connecting two wirings disposed in a two-layered structure.

An embodiment of the present invention can provide an activatable conductive link for connecting two wirings of aluminium or aluminium alloy disposed in the same level on an insulating layer.

In accordance with an embodiment of the present invention, there is provided a via hole, disposed in an insulator layer formed on a semiconductor substrate, having a high aspect ratio (a ratio of depth to inner diameter). Two aluminium or aluminium alloy wirings are formed respectively on the top and at the bottom surfaces of the insulator layer, being electrically insulated from each other by the insulating layer. The via hole has an electrically insulating side wall, electrically insulating and physically connecting the two wirings. If the connection of the two stacked aluminium wirings is required, a portion of an aluminium wiring in the vicinity of the via hole is irradiated by a shot of high energy excimer laser beam pulse irradiated from the top side. The aluminium included in the irradiated portion of the aluminium wiring is melted, being introduced into the via hole, and filling up the via hole. Thus, the via hole is changed to be conductive. The via hole acts as an activatable conductive link between the stacked aluminium wirings.

In a similar manner, another embodiment of the invention provides a trench or slot having a high aspect ratio (ratio of depth to lateral width) disposed in an insulator layer formed on a substrate of a semiconductor device such as an IC, the trench or slot intercepting an aluminium wiring formed on the insulator layer. The aluminium wiring is cut into two, forming two wirings which are electrically insulated from each other by the step portions (side walls) of the trench where the insulating layer is exposed. If the connection of the two aluminium wirings is required, the trench is filed up with melted aluminium by a shot of an excimer laser pulse in a similar manner to that described above, thus making the trench conductive. The trench, therefore, acts as an activatable conductive link for connecting two portions of conductive members placed in the same level.

Conductive links in accordance with the present invention can be particularly effectively employed in relation to master slice semiconductor device processes. The conductive links are small, on the order of µm, occupying a small substrate area of a device, and thus facilitating achievement of high density integration.

Reference is made, by way of example, to the accompanying drawings, in which:-
Fig. 1 is a cross-sectional view illustrating the structure of a previous conducting link;
Fig. 2 is a perspective view illustrating the structure of a conductive link in accordance with a first embodiment of the present invention;
Fig. 3 is a cross-sectional view of the conductive link of Fig. 2, taken along line A-A;
Fig. 4 is a cross-sectional view of a modified version of the conductive link of Fig. 2, including a via hole having an overhanging side wall;
Fig. 5 is a perspective view illustrating the structure of a conductive link in accordance with a second embodiment of the present invention;
Fig. 6 is a cross-sectional view of the conductive link of Fig. 5, taken along line B-B;
Fig. 7 is a cross-sectional view of a modified version of the conductive link of Fig. 5, including a trench having an overhanging side wall;
Fig. 8 is a cross-sectional view illustrating the structure of a conductive link in accordance with a third embodiment of the present invention;
Figs. 9(a) to 9(d) are respective cross-sectional views illustrating fabrication and activation of a conductive link in accordance with the first embodiment of the present invention;
Figs. 10(a) to 10(d) are respective cross-sectional views illustrating fabrication and activation of a conductive link in accordance with the second embodiment of the present invention;
Figs. 11(a) to 11(d) are respective cross-sectional views illustrating fabrication and activation of a conductive link in accordance with the first embodiment of the present invention; and
Figs. 12(a) to 12(d) are respective cross-sectional views illustrating fabrication and activation steps of a conductive link in accordance with the second embodiment of the present invention.

Figs. 2 is a perspective view of a part of a semiconductor device, partially broken away to reveal a structure, in accordance with a first embodiment of the present invention, providing an activatable conductive link (a via hole) for linking two aluminium wirings arranged in a two-layered structure and separated by a phosphorous silicate glass (PSG) layer. Fig. 3 is a cross-sectional view of the structure of Fig. 2, taken along line A-A shown in Fig. 2.

The semiconductor device shown in Fig. 2 and Fig. 3, has a two-layered structure; that is, in a portion of the device shown in Fig. 3, two aluminium wirings 8 and 11 are on two levels and have an insulator layer 9 of PSG interposed between them and are thereby electrically insulated from each other. The lower aluminium wiring 8 is formed on another insulator layer 7 of silicon dioxide (SiO₂) formed over a silicon substrate 6. A via hole 10 having a high aspect ratio (depth/diameter ratio), with a small diameter of 0.9 µm, and a large depth of 1.2 µm, for example, is disposed in a direction approximately normal to the principal plane of the substrate 6, physically extending between the upper and lower aluminium wirings 11 and 8. Thereby, the edges of the upper and lower mouths 10b and 10c of the via hole 10 respectively open onto or within the upper wiring 11 and the lower wiring 8. The side wall 10a of the via hole has a cylindrical PSG surface which is electrically insulative, having a high resistance sufficient to maintain the electrical insulation between the two aluminium wirings 8 and 11.

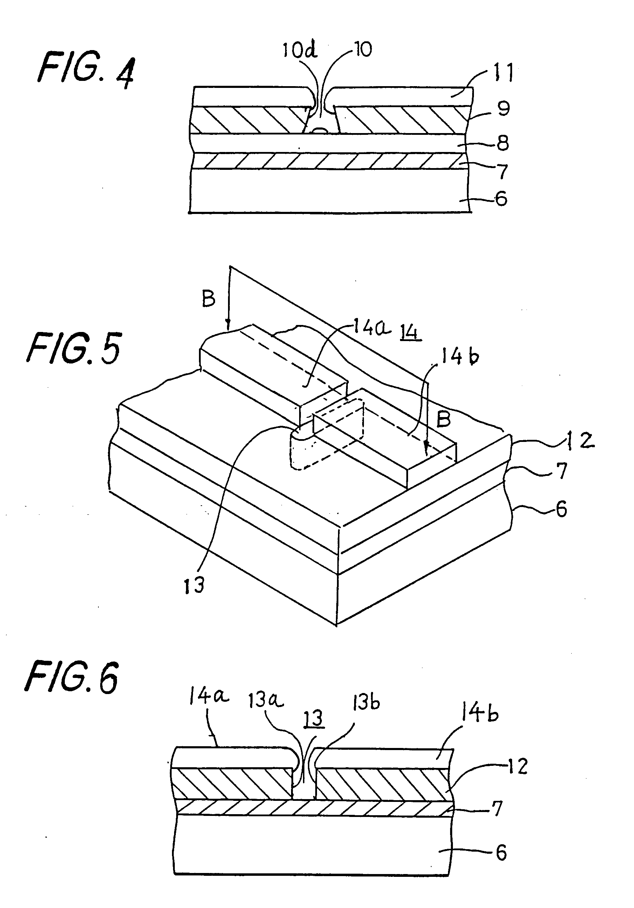

As will be described later, when the via hole 10 is opened in the PSG layer 9 before the formation of the upper aluminium wiring 11, the side wall 10a may be partially covered by aluminium deposited during an aluminium sputtering deposition process preceding the lithographic patterning of the aluminium wiring 11. However, the above-described electrical insulation is maintained thanks to the high aspect ratio of the via hole 10 and proper selection of an oblique sputtering angle for the aluminium vapour, which creates an effective shadowing effect for the sputtering. Furthermore, it is desirable for the via hole 10 to have overhanging side walls 10d, in order to achieve a more effective shadowing effect, as illustrated in the cross-sectional view of Fig. 4. An isotropic reactive gas etching process is suitable for providing overhanging side walls, as described later.

If the via hole 10 is opened up after formation of the upper aluminium wiring 11, then the above-described problem relating to the electrical insulation power of the side wall 10a is easily solved, although the durability of a mask used for lithographic patterning of the upper aluminium wiring is not high. To overcome this problem an opening having a form corresponding to the mouth of the via hole (or the trench - see below) may be opened in a predetermined portion of the wiring, and thereafter the via hole (or trench) may be formed with the aid of the above-described opening, as described below.

Fig. 5 is a perspective view of a part of a semiconductor device, partially broken away to reveal a structure in accordance with a second embodiment of the present invention, illustrating an activatable conductive link (a trench or a slot) for linking two aluminium wirings arranged on the same level formed on a phosphorous silicate glass (PSG) layer. Fig. 6 is a cross-sectional view of the structure of Fig. 5, taken along line B-B shown in Fig. 5.

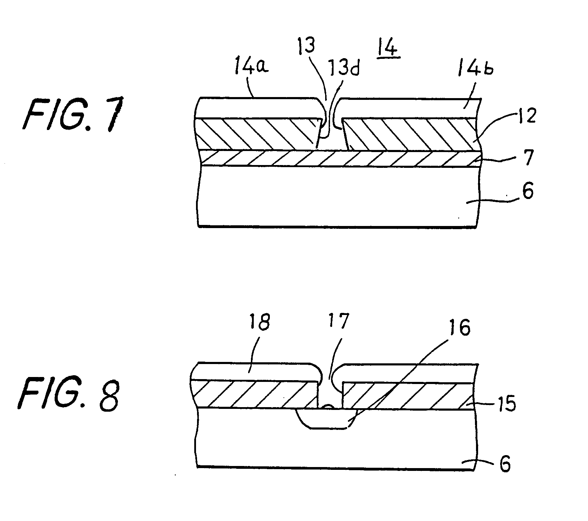

The semiconductor device shown in Fig. 5 and Fig. 6 is a one-layered structure: that is, the aluminium wirings are formed on one level. In the device, a PSG layer 12, and a silicon dioxide (SiO₂) layer 7 are formed on a silicon substrate 6. In the portion of the device shown in Fig. 6, two aluminium wirings 14a and 14b have between them a trench 13 formed in PSG layer 12. Both aluminium wirings 14a and 14b are formed on the PSG layer 12. The trench 13 has a small lateral length (width) of 0.9 µm and a large depth of 1.2 µm, for example, having a high aspect ratio of 1.33. The trench 13 extends depthwise in a direction approximately normal to the principal plane of the substrate 6, physically between, and electrically disconnecting, the aluminium wirings 14a and 14b. The width of the trench separates the wirings. The length of the trench 13 is shown in Fig. 5 as greater than the width of the aluminium wirings 14a and 14b, so that the edges 13b of the mouth of the trench 13 extend, longitudinally of the trench, beyond the side edges of the aluminium wirings 14a and 14b, providing a greater tolerance for alignment of the wirings 14a and 14b with the trench 13, if necessary. The side wall 13a of the trench has a PSG surface which is electrically insulative, having a high resistance, sufficient to maintain electrical insulation between the two aluminium wirings 14a and 14b. If the trench 13 is opened in the PSG layer 12 using an aluminium sputtering deposition, a problem may occur in that the side wall 13a is covered partially and undesirably with aluminium during the aluminium sputtering deposition. However, the problem is not so critical as with the first embodiment described above. This is because at least one of the side walls 13a of the trench 13, and the bottom surface thereof, are shaded from impinging aluminium vapour during the aluminium sputtering process due to the shadow effect of the aluminium sputtering deposition process. For reasons similar to the first embodiment, the trench 13 desirably has an overhanging side wall 13d as illustrated in the cross-sectional view of Fig. 7, which can be achieved by employing a reactive gas etching process for forming the trench, as described later.

Fig. 8 is a cross-sectional view illustrating a structure in accordance with a third embodiment of the present invention, which is modified form of the first embodiment, in which the lower aluminium wiring of the first embodiment is replaced by a doped conductive region. In this case, as shown in Fig. 8, a doped region 16, which is conductive, is formed in a silicon substrate 6 immediately beneath a via hole 17. An aluminium wiring 18 is insulated from the doped region 16 by a silicon dioxide (SiO₂) layer 15. The via hole 17 has a high aspect ratio, being capable of acting as a conducting link to connect the aluminium wiring 18 to the doping region 16 if so required.

In the three above-described embodiments, reference is made to aluminium wirings or aluminium layers. However, in place of aluminium other aluminium alloys such as aluminium silicon alloys and aluminium copper alloys which are conventionally used in semiconductor devices, are also applicable. Further, PSG layers 9 and 12 in the above-described embodiments can be replaced by other insulating, e.g. oxide layers, such as a silicon dioxide (SiO₂) layer, if the use thereof is permitted in the context of the production technology employed for the semiconductor device as a whole.

Fabrication and activation methods for activatable conductive links embodying the present invention will now be described.

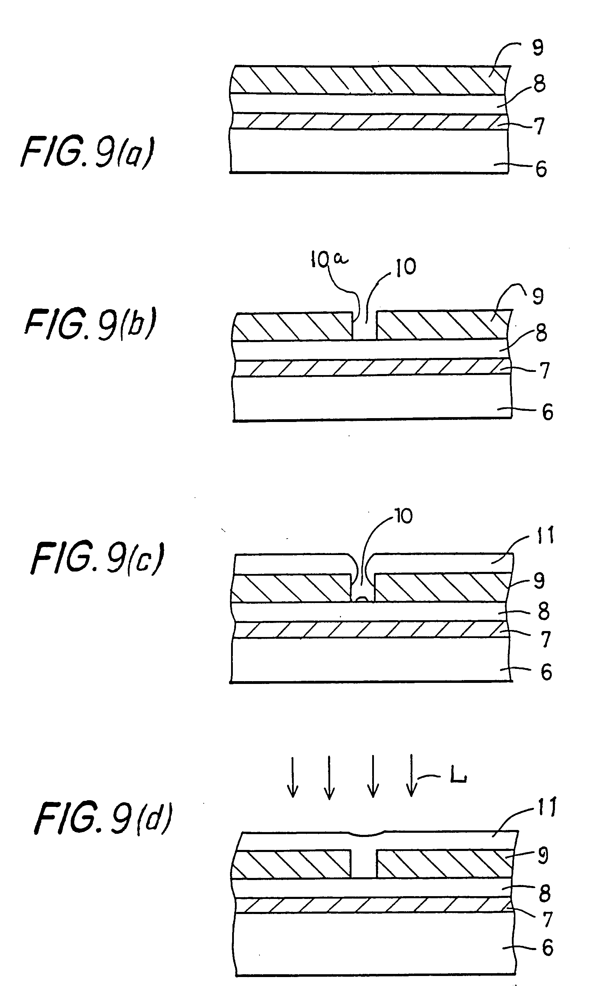

Figs. 9(a) to (d) illustrate fabrication and activation of an activatable conductive link in accordance with the first embodiment of the present invention.

Fig. 9(a) shows a stage reached after a silicon dioxide (SiO₂) layer 7 is formed over a silicon (Si) substrate 6, a lower aluminium layer is formed over the silicon dioxide layer 7, and subsequently, the lower aluminium layer is patterned to form a lower aluminium wiring 8. Further, a PSG layer 9 is formed over the aluminium wiring 8 and the silicon dioxide (SiO₂) layer. Thus a laminated structure is formed as shown in Fig. 9(a). This structure can be formed by conventional technology used in this field. To the laminated structure of Fig. 9(a), the following steps are applied in sequence:
(1) A via hole 10 is opened in the PSG layer 9, at a specified portion thereof, having a depth sufficient to reach the underlying lower aluminium wiring 8. The aspect ratio (depth/diameter ratio) of the via hole 10 is taken higher than 1.0. The via hole 10 can be opened by a conventional reactive ion etching method, which is an anisotropic etching method and is suitable for substantially precise patterning.
(2) Then, over the upper surface of the structure, aluminium is sputtered to form an upper aluminium layer, which is patterned thereafter to form an upper wiring 11. For this, the structure 6 is placed in a reaction chamber of an aluminium sputtering deposition apparatus (not shown) spaced from the source of aluminium vapour such that aluminium vapour impinges onto the structure obliquely, providing a shadow effect for the via hole 10 to ensure that a PSG side wall surface of the via hole 10 is uncovered by aluminium. Consequently, electrical insulation between the upper aluminium layer and the lower aluminium wiring 8 is assured. The angle of the direction of sputtering of aluminium vapour to the normal to the principal plane of the PSG layer 9 should be properly selected depending on the aspect ratio of the via hole 10. In the resulting structural configuration, the lower aluminium wiring 8 and the upper aluminium layer are still electrically insulated from each other. Subsequently, the upper aluminium layer is patterned in a conventional manner to form an upper aluminium wiring 11 as shown in Fig. 9(c).
(3) Thereafter, when electrical connection between the upper aluminium wiring 11 and the lower aluminium 8 is required, the aluminium layer 11 is irradiated from above with an excimer laser pulse spot of high energy and narrow pulse width, as indicated by arrows L in Fig. 9(d). The irradiated portion of the upper aluminium wiring 11 is instantaneously melted. The melted aluminium flows into the via hole 10, filling it up completely. As a result, the aluminium wiring 11 and the aluminium wiring 8 are electrically connected. The connection is substantially stable and reliable.

The excimer laser employed may be, for example, a pulsed Ar F excimer laser (wavelength: 193 nm), having an energy density of 10 J/cm² and a pulse width of 15 ns. In this case, one pulse shot is enough to activate the conductive link 10. A laser pulse shot of such high energy density and of such narrow pulse width serves to confine thermal diffusion to a small area in the vicinity of the irradiated target portion, preventing damage due to undesirable temperature increases, such as alloying of aluminium members with adjacent silicon members.

A low laser beam energy density, below 3 J/cm², is not effective to melt the aluminium of the relevant aluminium wirings instantaneously, and a high energy density, over 15 J/cm², is harmful in that aluminium wirings 8 and 11 may be damaged. Accordingly, an energy density in the range 5 to 12 J/cm² is desirable for practical use.

A longer pulse (having a width of 1µs, for example), or a continuous laser beam, may also cause damage, and not be suitable for practical use.

Other kinds of excimer laser, such as Kr F₂ excimer lasers (wavelength: 248 nm), Xe excimer lasers (wavelength: 308 nm), are available for use in this field.

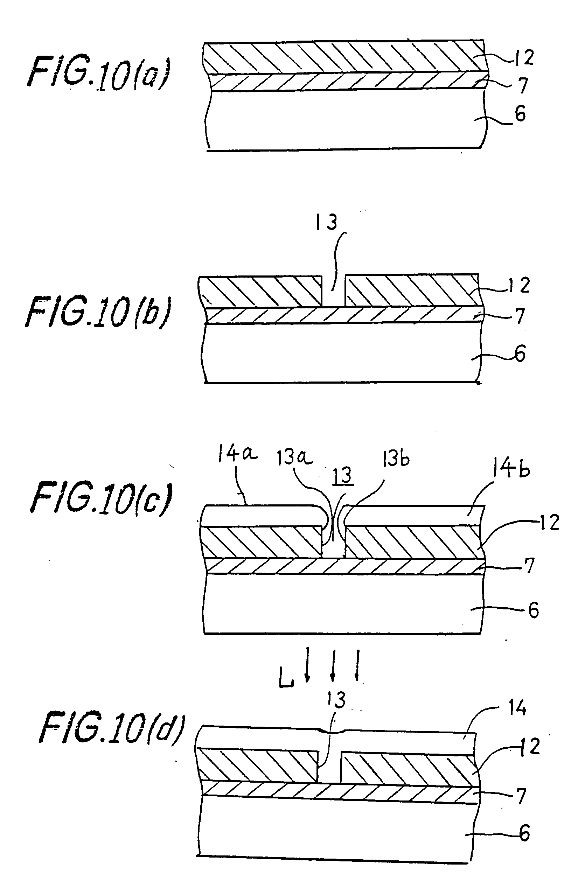

A method for fabricating an activatable conductive link in accordance with the second embodiment of the present invention is similar to that for the first embodiment. This method will be described briefly. A laminated structure comprising a PSG layer 12, a silicon dioxide (SiO₂) layer 7, and a substrate 6 is formed as illustrated in Fig. 10(a). Then, a trench 13 is opened in a selected portion of the PSG layer 12, employing a conventional reactive ion etching method, as shown in Fig. 10(b). Subsequently, an aluminium layer is formed over the PSG layer 12. Thereafter, the aluminium layer is patterned to form aluminium wirings 14a and 14b which are traversed by the trench 13 as shown in Fig. 10(c). The subsequent activation of the conductive link is performed in the same manner as for the first embodiment, and further description thereof is omitted here. Fig. 10(d) illustrates the state of the conductive link of the second embodiment after activation.

As already indicated above, it is important to secure a portion of the PSG surface of the side wall (10a, 10d) of the via hole (or trench 13a, 13d) which is free from deposition of aluminium.

An effective method for securing the insulating capability of the via hole (or trench) is provided by the use of a conventional lift-off process using, for example, photoresist resin. The via hole 10 (or trench) is filled up with the resin in advance, before aluminium deposition over the via hole (or trench), preventing deposition of aluminium on the side wall. Thereafter, the resin is removed from the via hole (or trench).

Another method, already described above, is to form the via hole (or trench) with overhanging side walls by employing a conventional reactive gas etching method for opening the via hole. The employed etchant gas is a mixture of tetrafluoride carbon (CF₄) and trifluoromethane (CHF₃), for example. Because the etching method is essentially isotropic and the adhesion between a mask (not shown) and the PSG layer 9 is very strong the resulting via hole is subject to so-called "under etching", which provides overhanging side walls (10d, 13d) as shown in Fig. 4 or Fig. 7, which is effective to provide the side wall with a strong shadow effect during aluminium deposition, with the result that an exposed PSG portion of the side wall is secured.

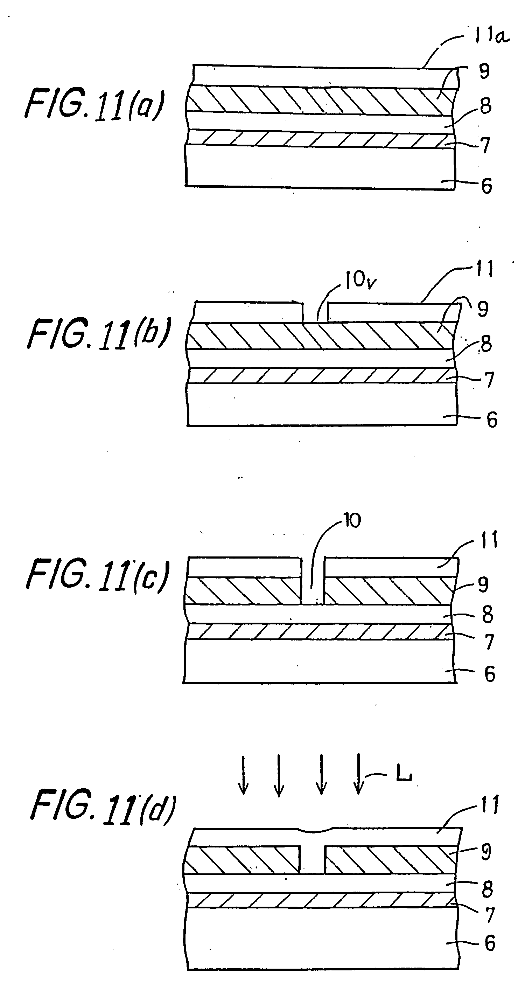

A definitely effective method is to open a via hole after patterning the upper aluminium wiring 11. This method is described with reference to Figs. 11. As shown in Fig. 11(a), an upper aluminium layer 11a, a PSG layer 9, a lower aluminium wiring 8, a silicon dioxide (SiO₂) layer 7 and a silicon substrate 6 are laminated as illustrated, formed by conventional semiconductor device fabricating methods. The upper aluminium layer 11a is then patterned to form an upper aluminium wiring 11, as shown in Fig. 11(b), including a via hole pattern 10v opened amid the pattern of the upper aluminium wiring 11, at a predetermined location, by employing a mask (not shown).

Then, the PSG layer 9 immediately beneath the via hole pattern 10v is etched by a conventional reactive ion etching method, or a conventional reactive gas etching method, until the formed hole reaches the underlying lower aluminium wiring 8. The thus opened via hole 10 has a side wall 10a having an entirely exposed PSG surface. The conductive link is completed as shown in Fig. 11(c). The activating method for this via hole 10 is as described above, and the resulting activated link is shown in Fig. 11(d).

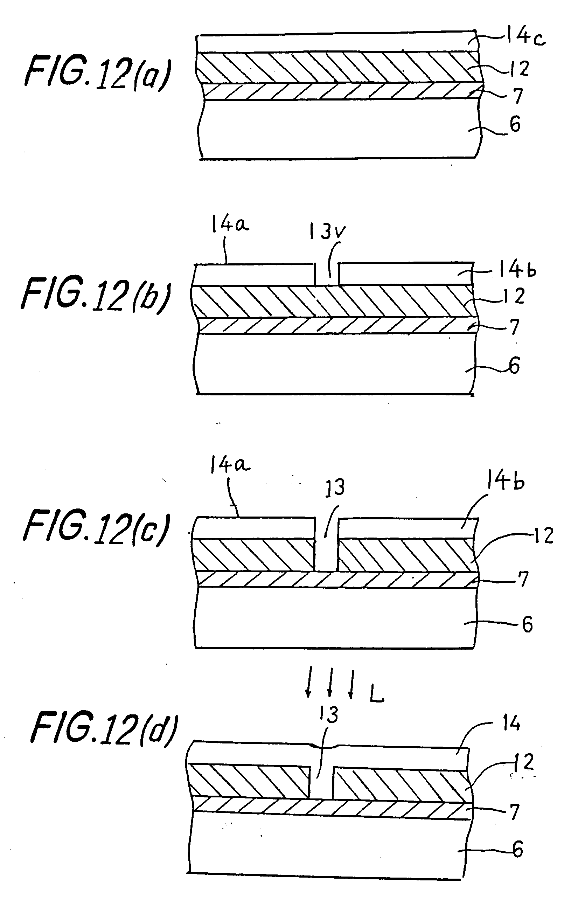

A method of fabricating an activatable conductive link in accordance with the second embodiment of the present invention is similar to that of the first embodiment. The fabricating method thereof, therefore, is described only briefly. A laminated structure comprising an aluminium layer 14c, a PSG layer 12, a silicon dioxide (SiO₂) layer 7, and a substrate 6 laminated in the illustrated order is formed as shown in Fig. 12(a). Then, the aluminium layer 14c is patterned to form an aluminium wiring 14 including a traversing slit pattern 13v disposed at a position where a trench 13 is to be disposed, as shown in Fig. 12(b). Subsequently, the trench 13 is opened in the PSG layer 12 below the slit 13v employing a conventional drying etching process, as shown in Fig. 12(c). As a result, the aluminium wiring 14 is traversed by the trench 13, and separated into aluminium wirings 14a and 14b as shown in Fig. 12(c). Since the subsequent activation method is the same as that of the first embodiment, further description thereof is omitted. Fig. 12(d) illustrates the state of the conductive link after activation thereof.

With regard to the activation process of a conducting link of the second embodiment, it should be noted that the trench 13 plays an important role in the achievement of a reliable connection between the associated aluminium wirings. Melted aluminium flows into the trench, filling up the trench 13 and planarizing the cut portion between the wirings. The resulting connection is strong and stable. Without the trench 13, aluminium at the connecting point would overflow in the vicinity of the laser pulse irradiated portion, resulting in an unreliable connection between the wirings to be connected.

The method for fabricating a structure in accordance with the third embodiment of the present invention is the same as that of the first embodiment except for the formation in advance of a doped region 16 in the substrate 6.

According to embodiments of the present invention, as described above, an activatable conductive link is formed between two aluminium wirings in a semiconductor device, which are insulated from each other by an insulating layer. The conductive link is formed using a via hole or a trench with a high aspect ratio, disposed in the insulating layer. When necessary, the two aluminium wirings are easily connected using a simple method, namely irradiation with one shot of an excimer laser beam pulse. In addition, the contact area (e.g. the via hole area), occupying a small area on the relevant silicon substrate. The insulating capability of the link before activation thereof, and the conducting capability of the link after activation thereof, are both substantially stable and reliable. As a result, a semiconductor device with a high integration density can be produced in a master slice system with low cost and high reliability.

The present invention provides and includes within its scope a conducting link, in an integrated semiconductor circuit of a semiconductor device, in combination with a plurality of conductive paths including a first conductive path and a second conducting path which are electrically insulated from each other by an insulating layer, disposed between said conductive paths in a specified portion of the circuit, being selectively activatable to provide a conductive link path between said conductive paths, comprising:
a concaved portion having a high aspect ratio formed in said insulating layer, physically contacting with said first conductive path and said second conductive path, and electrically maintaining the insulation between said first and second conductive paths.

The concaved portion may have a mouth edge which contacts to said first conductive path and said second conductive path at portions thereof separated from each other, and an inside surface which is insulative enough to maintain the electrical insulation between said first and second conductive paths.

The first conductive path may be made of metal, for example aluminium or aluminium alloy.

The insulating layer may be a phosphorous silicate glass (PSG) layer or a silicon dioxide (SiO₂) layer.

The first conductive path and said second conductive path may be arranged in a two-layered arrangement interposed by said insulating layer, said concaved portion being a via hole which has a side wall with insulative surface, and an upper mouth edge and a lower mouth edge respectively physically contacting with said first conductive path and said second conductive path.

The via hole may be a circular hole having an aspect ratio which is defined as a ratio of the depth to the inner diameter, higher than 1.0.

The side wall of the via hole may be overhanging.

The surface of said second conductive path may be exposed at the lower mouth of said via hole.

The second conducting path may be disposed on an insulating layer over a semiconductor substrate of said semiconductor device.

The second conductive path may be a conductive doped region formed in a semiconductor substrate of said semiconductor device.

The first conductive path and said second conductive path may be formed on said first insulating layer in the same level, said concaved portion being a trench having an insulative side wall and a mouth edge of which is in contact with said first conductive path and said second conductive path at mutually facing portions of said mouth edge.

The trench may have an aspect ratio defined as a ratio of the depth to the lateral width of said trench, higher than 1.0.

The side wall of said trench may be overhanging.

The present invention also provides and includes within its scope a method for creating and activating a conducting link, in an integrated semiconductor circuit of a semiconductor device, selectively activatable in combination with a plurality of conducting paths which are electrically insulated from each other by a first insulating layer, said method comprising the steps of:
(a) forming a concaved portion with a high aspect ratio in said first insulating layer at a specified portion;
(b) forming a first conductive path of metal such that said first conducting path is electrically insulated by said concaved portion from another second conducting path to which said first conducting path is to be connected; and
(c) activating said conducting link, when activation is required, by locally heating said concaved portion and a region in the vicinity thereof, melting metal contained in the heated portion of said first conducting path, making the melted metal flow into said concaved portion to fill up said concaved portion with said metal, and thus providing a conductive path between said first and second conductive paths.

The first conducting path may be made of aluminium or aluminium alloy.

The local heating may employ an energy beam pulse.

The energy beam may be an excimer laser beam.

The energy density of said excimer laser beam is preferably in the 5 J/cm² to 12 J/cm².

The first conductive path and said second conductive path may be arranged in a two-layered arrangement interposed by said first insulating layer, said concaved portion being a via hole, and said second conductive path being made of aluminium or aluminium alloy formed over an insulating layer formed over a semiconductor substrate, or made of a doped conductive region formed in said semiconductor substrate.

Process (a) above may comprise, forming said via hole in said first insulator at a specified portion such that said via hole reaches said underlying second conducting path, and
process (b) above may comprise, forming an aluminium or aluminium alloy layer over said second insulating layer including said via hole, and patterning said layer to form said first conductive path in alignment with said via hole, thus creating a conducting link which is in an insulating state.

The first conductive path and said second conductive path may be arranged on said first insulating layer in the same level, said concaved portion being a trench having an insulative side wall.

In this case process (a) above may comprise, forming said trench in said first insulator at said specified portion,
process (b) above may comprise, forming an aluminium or aluminium alloy layer over said first insulating layer, including said trench, and patterning said layer to form said first and second conductive paths in alignment with said trench such that both of said first and second conductive paths are insulated from each other and are respectively in contact with mutually facing portions of the mouth edge of said trench.

The via hole or trench may be formed in said first insulating layer so as to have overhanging side wall in said via hole or said trench employing an isotropic reactive etching method.

The present invention further provides and includes within its scope a method for creating and activating a conducting link, in an integrated semiconductor circuit of a semiconductor device, selectively activatable in combination with a plurality of conducting paths which are electrically insulated from each other by a first insulating layer, said method comprising the steps of:
(a) forming a first conductive path of aluminium or aluminium alloy over said first insulating layer, said first conducting path including a pattern of a mouth of said concaved portion at a specified portion where said conducting link is to be disposed;
(b) forming a concaved portion with a high aspect ratio in said first insulating layer, utilizing said pattern of the mouth of said concaved portion, at said specified portion such that said first conducting path is electrically insulated by said concaved portion from said second conducting path to which said first conducting path is to be connected; and
(c) activating said conducting link, when activation is required, by locally heating said concaved portion and a region in the vicinity thereof, melting metal contained in the heated portion of said first conducting path, making the melted metal flow into said concaved portion to fill up said concaved portion with said metal, and thus providing a conductive path between said first and second conductive paths.

A conducting link disposed in an insulating layer of a semiconductor device in combination with a plurality of wirings of the device which are electrically separated from each other. The conductive link is selectively activated, providing the wirings with a conducting path, and is activatable by melting metal contained in the wirings by irradiating the portion in the vicinity of the link with a shot of a pulse of laser beam. The link comprises a via hole or a trench disposed in the insulating layer depending on the structural configuration of the device. The method of fabricating and activating the conductive link is provided.

## Claims

1. An activatable conductive link structure in a semiconductor device, the structure comprising in its non-activated, non-conductive, configuration, a void in an insulating layer of the semiconductor device across which void conductive parts of the device confront one another, the void being such that conductive material does not extend to such an extent on inner walls of the void as to establish conductive connection between the conductive parts, and such that upon activation of the link conductive material of at least one of the confronting conductive parts melts and fills the void to establish a conductive link between the conductive parts.

2. A structure as claimed in claim 1, wherein at least one of the confronting conductive parts, which melts upon activation, is of metal, for example aluminium or aluminium alloy.

3. A structure as claimed in claim 1 or 2, wherein the insulating layer is of phospho silicate glass (PSG) or of silicon dioxide.

4. A structure as claimed in claim 1, 2 or 3, wherein the confronting conductive parts are parts of respective conductive layers, one above the insulating layer, one below the insulating layer, or are, respectively, a part of a conductive layer above the insulating layer and a part of a doped conductive device substrate region below the insulating layer, and the void is a via hole through the insulating layer.

5. A structure as claimed in claim 1, 2 or 3, wherein the confronting conductive parts are both formed on an upper surface of the insulating layer and the void is a trench, slot or hole in the insulating layer.

6. A structure as claimed in any preceding claim, wherein the side walls of the void, defined by material of the insulating layer, are overhanging.

7. A structure as claimed in any preceding claim, wherein the void has an aspect ratio, i.e ratio of depth into the insulating layer to upper opening width, of 1.0 or more.

8. A method of forming and activating an activatable conductive link structure in a semiconductor device, the method comprising
forming a void in an insulating layer of the device with conductive parts of the device confronting one another across the void, to provide a non-conductive, non-activated link structure, the void being such that conductive material does not extend to such an extent on inner walls of the void as to establish conductive connection between the conductive parts,
and activating the link structure by locally heating a region in the vicinity of the void such that conductive material of at least one of the conductive parts melts and fills the void to establish a conductive link between the conductive parts.

9. A method as claimed in claim 8, wherein the local heating is accomplished using an energy beam pulse, for example an excimer laser beam pulse.

10. A method as claimed in claim 9, wherein an excimer laser beam pulse of energy density in the range 5 J/cm² to 12 J/cm² is employed.

11. A method as claimed in any one of claims 8 to 10, wherein the insulating layer is formed over one of the conductive parts, which may belong to a conductive layer or a doped conductive device substrate region, and the other conductive part is part of a conductive layer formed over the insulating layer, the void being formed as a via hole through the insulating layer.

12. A method as claimed in any one of claims 8 to 10, wherein the conductive parts are parts of a conductive layer formed over the insulating layer and the void is formed as a trench, slot or hole formed in the insulating layer.

13. A method as claimed in any one of claims 8 to 12, wherein the side walls of the void, defined by material of the insulating layer, are formed so as to be overhanging, employing an isotropic reactive etching method.

14. A method as claimed in any one of claims 8 to 13, wherein the void in the insulating layer is formed prior to formation of the conductive layer over the insulating layer.

15. A method as claimed in any one of claims 8 to 13, wherein the void in the insulating layer is formed after formation of the conductive layer over the insulating layer, using an aperture provided in the conductive layer as a pattern for etching the void into the insulating layer.

## Patentansprüche

1. Aktivierbare Leitungsverbindungs-Struktur in einer Halbleiteranordnung, welche Struktur in ihrer nicht aktivierten, nicht leitenden Konfiguration eine Lücke in einer Isolierschicht der Halbleiteranordnung umfaßt, über die sich leitungsfreie Teile der Anordnung einander gegenüberstehen, wobei die Lücke so ausgebildet ist, daß sich leitendes Material nicht in solch einem Ausmaß auf die inneren Wände der Lücke erstreckt, daß eine leitende Verbindung zwischen den Leitungsteilen hergestellt wird, und so ausgebildet ist, daß bei Aktivierung der Verbindung leitendes Material von wenigstens einem der einander gegenüberstehenden leitenden Teile schmilzt und die Lücke füllt, um eine Leitungsverbindung zwischen den leitenden Teilen herzustellen.

2. Struktur wie in Anspruch 1 beansprucht, worin mindestens einer der sich gegenüberstehenden leitenden Teile, welcher bei Aktivierung schmilzt, aus Metall, z.B. aus Aluminium oder einer Aluminiumlegierung, ist.

3. Struktur wie in Anspruch 1 oder 2 beansprucht, worin die isolierende Schicht aus Phosphosilikat-Glas (PSG) oder aus Siliziumdioxid ist.

4. Struktur wie in Anspruch 1, 2 oder 3 beansprucht, worin die einander gegenüberstehenden leitenden Teile Teile von entsprechenden leitenden Schichten sind, eine über der isolierenden Schicht, eine unter der isolierenden Schicht, oder sie ein Teil einer leitenden Schicht über der isolierenden Schicht und ein Teil eines dotierten leitenden Substratbereichs der Anordnung unter der isolierenden Schicht sind, und worin die Lücke ein Durchgangsloch durch die isolierende Schicht ist.

5. Struktur wie in Anspruch 1, 2 oder 3 beansprucht, worin die einander gegenüberstehenden leitenden Teile beide auf einer oberen Oberfläche der isolierenden Schicht gebildet sind, und worin die Lücke ein Graben, Schlitz oder Loch in der isolierenden Schicht ist.

6. Struktur wie in irgendeinem vorhergehenden Anspruch beansprucht, worin die Seitenwände der Lücke, welche durch das Material der isolierenden Schicht definiert werden, überhängend sind.

7. Struktur wie in irgendeinem vorhergehenden Anspruch beansprucht, worin die Lücke ein Längenverhältnis besitzt, das ist das Verhältnis der Tiefe in die isolierende Schicht zur oberen Öffnungsbreite, von 1,0 oder mehr.

8. Verfahren zum Bilden und Aktivieren einer aktivierbaren Leitungsverbindungs-Struktur in einer Halbleiteranordnung, welche Methode umfaßt:
Bilden einer Lücke in einer Isolierschicht der Anordnung mit einander über der Lücke gegenüberstehenden, leitenden Teilen der Anordnung, um eine nicht leitende, nicht aktivierte Verbindungsstruktur vorzusehen, wobei die Lücke so ausgebildet ist, daß sich leitendes Material nicht in solch einem Ausmaß auf die inneren Wände der Lücke erstreckt, daß eine leitende Verbindung zwischen den leitenden Teilen hergestellt wird,
und Aktivieren der Verbindungsstruktur durch lokale Erwärmung eines Bereiches in der Nähe der Lücke so, daß leitendes Material von zumindest einem der leitenden Teile schmilzt und die Lücke füllt, um eine Leitungsverbindung zwischen den leitenden Teilen herzustellen.

9. Verfahren wie in Anspruch 8 beansprucht, worin das lokale Erhitzen unter Verwendung eines Energiestrahl-Impulses erreicht wird, z.B. eines Exzimerlaserstrahl-Impulses.

10. Verfahren wie in Anspruch 9 beansprucht, worin ein Exzimerlaserstrahl-Impuls mit einer Energiedichte im Bereich von 5 J/cm² bis 12 J/cm² angewendet wird.

11. Verfahren wie in einem der Ansprüche 8 bis 10 beansprucht, worin die isolierende Schicht über einem der leitenden Teile gebildet ist, welcher einer leitenden Schicht oder einer dotierten leitenden Anordnung des Substratbereiches angehört, und worin der andere leitende Teil Teil einer leitenden Schicht ist, welche über der isolierenden Schicht gebildet ist, wobei die Lücke als Durchgangsloch durch die isolierende Schicht ausgeführt ist.

12. Verfahren wie in irgendeinem der Ansprüche 8 bis 10 beansprucht, worin die leitenden Teile Teile einer leitenden Schicht sind, welche über der isolierenden Schicht gebildet ist und worin die Lücke als in der isolierenden Schicht gebildeter Graben, Schlitz oder Loch ausgeführt ist.

13. Verfahren wie in irgendeinem der Ansprüche 8 bis 12 beansprucht, worin die Seitenwände der Lücke, definiert durch das Material der isolierenden Schicht, so ausgeführt sind, daß sie überhängend sind, unter Anwendung eines isotropen reaktiven Ätzverfahrens.

14. Verfahren wie in irgendeinem der Ansprüche 8 bis 13 beansprucht, worin die Lücke in der isolierenden Schicht vor der Bildung der leitenden Schicht über der isolierenden Schicht gebildet wird.

15. Verfahren wie in irgendeinem der Ansprüche 8 bis 13 beansprucht, worin die Lücke in der isolierenden Schicht nach der Bildung der leitenden Schicht über der isolierenden Schicht gebildet wird, unter Verwendung einer Öffnung, welche in der leitenden Schicht als ein Muster zum Ätzen der Lücke in die isolierende Schicht vorgesehen ist.

## Revendications

1. Liaison conductrice activable dans un dispositif semi-conducteur, la structure comprenant dans son état non conducteur, non activé, un vide dans une couche isolante du dispositif semi-conducteur, en travers duquel vide des éléments conducteurs du dispositif se font face l'un à l'autre, le vide étant tel que le matériau conducteur ne s'étende pas jusqu'à une distance, par rapport aux parois intérieures du vide, telle qu'il établisse une connexion conductrice entre les éléments conducteurs, et telle que lors de l'activation de la liaison le matériau conducteur, d'au moins l'un des éléments conducteurs qui se font face, fonde et remplisse le vide pour établir une liaison conductrice entre les éléments conducteurs.

2. Structure selon la revendication 1, dans laquelle au mois l'un des éléments conducteurs qui se font face, qui fond lors de l'activation, est fait de métal, par exemple de l'aluminium ou un alliage d'aluminium.

3. Structure selon la revendication 1 ou 2, dans laquelle la couche isolante est faite de verre de phospho-silicate (PSG) ou de dioxyde de silicium.

4. Structure selon la revendication 1, 2 ou 3, dans laquelle les éléments conducteurs qui se font face sont des éléments de couches conductrices situées, respectivement, une au-dessus de la couche isolante, une au-dessous de la couche isolante, ou sont, respectivement, un élément d'une couche conductrice au-dessus de la couche isolante et un élément d'une région de substrat de dispositif conducteur dopée au-dessous de la couche isolante, et le vide est un trou traversant qui traverse la couche isolante.

5. Structure selon la revendication 1, 2 ou 3, dans laquelle les éléments conducteurs qui se font face sont tous les deux formés sur une surface supérieure de la couche isolante et dans laquelle le vide est une tranchée, une rainure ou un trou dans la couche isolante.

6. Structure selon l'une quelconque des revendications précédentes dans laquelle les parois latérale du vide, défini par le matériau de la couche isolante, sont en surplomb.

7. Structure selon l'une quelconque des revendications précédentes dans laquelle le vide a un rapport d'allongement, c'est-à-dire le rapport de la profondeur dans la couche isolante à la largeur de l'ouverture supérieure, de 1,0 ou davantage.

8. Procédé de formation et d'activation d'une structure de liaison conductrice activable dans un dispositif semi-conducteur, le procédé comprenant :
la formation d'un vide dans une couche isolante du dispositif, avec des éléments conducteurs du dispositif qui se font face l'un à l'autre en travers du vide, pour créer une structure de liaison non conductrice, non activée, le vide étant tel que le matériau conducteur ne s'étende pas sur les parois intérieures du vide sur une distance telle qu'il établisse une connexion conductrice entre les éléments conducteurs, et
l'activation de la structure de liaison en chauffant localement une région dans le voisinage du vide, de tel manière que le matériau conducteur d'au moins l'un des éléments conducteurs fonde et remplisse le vide pour établir une liaison conductrice entre les éléments conducteurs.

9. Procédé selon la revendication 8, dans lequel l'échauffement local est réalisé en utilisant une impulsion de faisceau d'énergie, par exemple une impulsion de rayon laser excimer.

10. Procédé selon la revendication 9, dans lequel une impulsion de rayon laser excimer d'une densité d'énergie dans la plage de 5 J/cm² à 12 J/cm², est utilisée

11. Procédé selon l'une quelconque des revendications 8 à 10, dans lequel la couche isolante est formée sur l'un des éléments conducteurs qui peut appartenir à une couche conductrice ou à une région de substrat de dispositif conducteur dopée et l'autre élément conducteur est un élément d'une couche conductrice formée sur la couche isolante, le vide ayant la forme d'un trou traversant qui traverse la couche isolante.

12. Procédé selon l'une quelconque des revendications 8 à 10, dans lequel les éléments conducteurs sont des éléments d'une couche conductrice formée sur la couche isolante et dans lequel le vide a la forme d'une tranchée, d'une fente ou d'un trou formés dans la couche isolante.

13. Procédé selon l'une quelconque des revendications 8 à 12, dans lequel les parois latérales du vide , définies par le matériau de la couche isolante, sont formées de façon a être en surplomb, en utilisant un procédé de gravure réactive isotrope.

14. Procédé selon l'une quelconque des revendications 8 à 13, dans lequel le vide dans la couche isolante est formé avant la formation de la couche conductrice sur la couche isolante.

15. Procédé selon l'une quelconque des revendications 8 à 13, dans lequel le vide dans la couche isolante est formé après la formation de la couche conductrice sur la couche isolante, en utilisant une ouverture prévue dans la couche conductrice sous la forme d'un dessin pour graver le vide dans la couche isolante.
